# EUROPEAN PATENT APPLICATION

(11) **EP 1 014 583 A1**
(43) Date of publication of application: **28.06.2000**
(21) Application number: 99310010.6
(22) Date of filing: 13.12.1999
(51) Int. Cl.: H03K 19/003, H03K 17/16

(54) **Multi-stage data anticipation driver and method for an integrated circuit device**

(30) Priority: 17.12.1998 US 212537
(71) Applicant: UNITED MEMORIES, INC., Colorado Springs, CO 80919 (US); Nippon Steel Semiconductor Corp., Tateyama-shi, Chiba 294 (JP)
(72) Inventor: Meadows, Harold Brett, Colorado Springs, Colorado 80920 (US)
(74) Representative: Driver, Virginia Rozanne

(57) **Abstract**

A multi-stage data anticipation driver for an integrated circuit device includes a multi-stage data driver in which a first stage (124,134) initially turns "on" inducing a relatively small rate of change of current (*di/dt*) at an output data node. After a short predetermined delay, a second subsequent stage (132,142) turns on which provides another small *di/dt*. By step-wise controlling the rate of change in *di/dt* in this fashion, noise on the power supply lines is greatly limited. Following another short, predetermined delay, the second stage (132,142) turns "off" leaving only the first stage driver (124,134) driving the output data node and then only the first stage driver need turn "off" when opposite state data is read. Switching time for the first stage driver (124,134) can be made rapid by the reduction in device size allowed by the multi-stage configuration which also serves to limit the maximum possible crowbar current flow between the power supply lines.

## Description

The present invention relates, in general, to the field of integrated circuit ("IC") devices. More particularly, the present invention relates to a multi-stage data anticipation driver and method for an integrated circuit device which effectively controls the rate of change in device current when outputting data at an output data node.

Many current integrated circuit devices utilize a single stage output buffer to provide output data. While relatively simple in concept and implementation, these designs nevertheless require very large transistors to accommodate desired output speed requirements. The size of these devices causes several problems. First, large transistors add a concomitantly greater capacitance to the complementary data inputs (usually denominated high data bar ["HIDATB"] and low data ["LODAT"])to the output buffer thereby requiring larger drivers to drive these signals to maintain acceptable device speed. Further, when a single transistor in the output buffer turns "on", a relatively large rate of change in current through the buffer (*di*/*dt*) is experienced causing undesired noise on the associated power supply sources. Still further, when a single stage output buffer switches from one data state to the other, for a brief interstitial time period, both transistors are "on" thereby causing excessive current flow ("crowbar" current) between the VCC and VSS voltage sources across the output buffer.

Disclosed herein is a multi-stage data anticipation driver and method for an integrated circuit which obviates the shortcomings of prior single stage data driver circuit techniques. Disclosed herein is a circuit and method for controlling *di/dt* by utilizing a multi-stage driver. In operation, a first stage having transistors which can be made smaller than those of single stage output buffers turns "on" followed after a predetermined time period by a second comparably sized stage. After a given data state is achieved, the second stage turns "off" to minimize the capacitive load seen by the circuitry driving the first stage and to minimize the maximum possible crowbar current. Particularly, by providing for reduced transistor width devices in a first stage, less capacitive loading is placed on the circuitry driving the HIDATB and LODAT signals and, since the subsequent stage turns off once the new data state is achieved, only the first stage is needed to drive the output data node.

In this manner, the present invention also advantageously controls *di/dt* through its sequential and selective turning "on" or "off" in stages, since by turning on two different driver stages at different times, the maximum *di/dt* can be controlled. Still further the driver of the present invention provides a reduction in the maximum possible "crowbar" current. Because of the reduced device size and capacitive load on HIDATB and LODAT, the first driver stage can turn "off" quickly which can minimize the brief time that current can flow from VCC to VSS through the output transistors. This current may also be limited by the reduced gate width of the first stage.

Particularly disclosed herein is an integrated circuit device which includes a data driver for receiving an input data signal and supplying the same to an output data node. The data driver comprises a first stage driver coupled to receive the input data signal and is also coupled to the output data node for supplying the input data signal to the output data node. A second stage driver is also coupled to receive the input data signal and to the output data node for also supplying the input data signal to the output data node.

Further disclosed herein is a method for driving an input data signal to an output data node in an integrated circuit device. The method comprises the steps of receiving the input data signal at a first stage driver; coupling the input data signal to the output data node through the first stage driver; also receiving the input data signal at a second stage driver and also coupling the input data signal to the output data node through the second stage driver.

The aforementioned and other features and objects of the present invention and the manner of attaining them will become more apparent and the invention itself will be best understood by reference to the following description of a preferred embodiment, given by way of example, taken in conjunction with the accompanying drawings, wherein:
Fig. 1 is a schematic illustration of a prior art data driver circuit comprising a single pull-up transistor for driving data to a "high" voltage level and a corresponding pull-down transistor for driving data to a "low" voltage level;
Fig. 2 is a schematic and logic block representation of a multi-stage data anticipation driver in accordance with one embodiment of the present invention; and
Figs. 3A, 3B and 3C illustrate various inverter configurations that may be utilized alone or in combination to construct the inverting amplifiers shown in Fig. 2 for introducing predetermined delays into a multi-stage data anticipation driver.

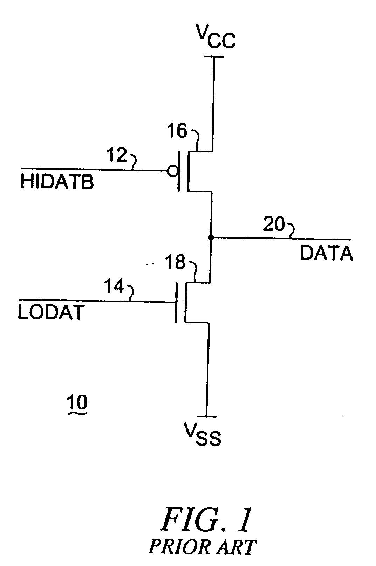

With reference now to Fig. 1, a typical prior art data driver circuit 10 is shown. The data driver circuit 10 comprises a high data bar ("HIDATB") input 12 and a low data ("LODAT") input 14 to a pair of series connected p-channel and n-channel transistors 16, 18 coupled between a first voltage level source ("VCC") and a second voltage level source ("VSS"). A data output 20 is defined as the node intermediate the p-channel transistor 16 and n-channel transistor 18.

The p-channel transistor 16 is utilized to drive data to be output from an integrated circuit device to a relatively "high" voltage level (i.e. VCC) and the n-channel transistor 18 is used to drive data to a low voltage level (VSS). In order to read a "high" level out of the data driver circuit 10, inputs 12 and 14 are both driven to a logic "low" level. This turns "on" the p-channel transistor 16 and turns "off" the n-channel transistor 18 thereby pulling the data output to near VCC. Conversely, in order to read a "low" level out of the data driver circuit 10, inputs 12 and 14 are both driven to a logic "high" level. This transition turns "on" the n-channel transistor 18 and turns "off" the p-channel transistor 16 thereby pulling the data output to a level of near VSS.

While an extremely simple circuit implementation, there are a number of critical drawbacks in the use of but a single pull-up transistor (p-channel transistor 16) and a single pull-down transistor (n-channel transistor 18) in an integrated circuit device data driver circuit 10. First, both transistors 16, 18 must be laid out as relatively large devices to accommodate desired data output speed requirements thereby resulting in greater capacitance on the HIDATB and LODAT inputs 12, 14 which, in turn, then requires larger drivers to the inputs 12, 14 to maintain data output speed.

Secondly, the data driver circuit 10 makes it very difficult to control the rate of change in current in the integrated circuit device over time (*di/dt*). For example, assuming both transistors 16, 18 are "off" (i.e. data is in tri-state), when the HIDATB signal on input 12 equals the threshold voltage of transistor 16 (Vtp) or the LODAT signal on input 14 equals the threshold voltage of transistor 18 (Vtn) the affected transistor will turn "on" with a resultant sharp increase in current flow. Still further, if one of the transistors 16, 18 is "on" and sourcing (or sinking) current, turning "off" the opposite transistor will also cause a sharp change in device current.

Finally, in order to achieve the maximum switching speed for the data driver circuit 10, the HIDATB and LODAT signals should ideally switch at the same time. Because there is a finite rise and fall time associated with switching the HIDATB and LODAT signals, there can be a time when both transistors 16 and 18 are essentially "on" and "crowbar" current flows from VCC to VSS.

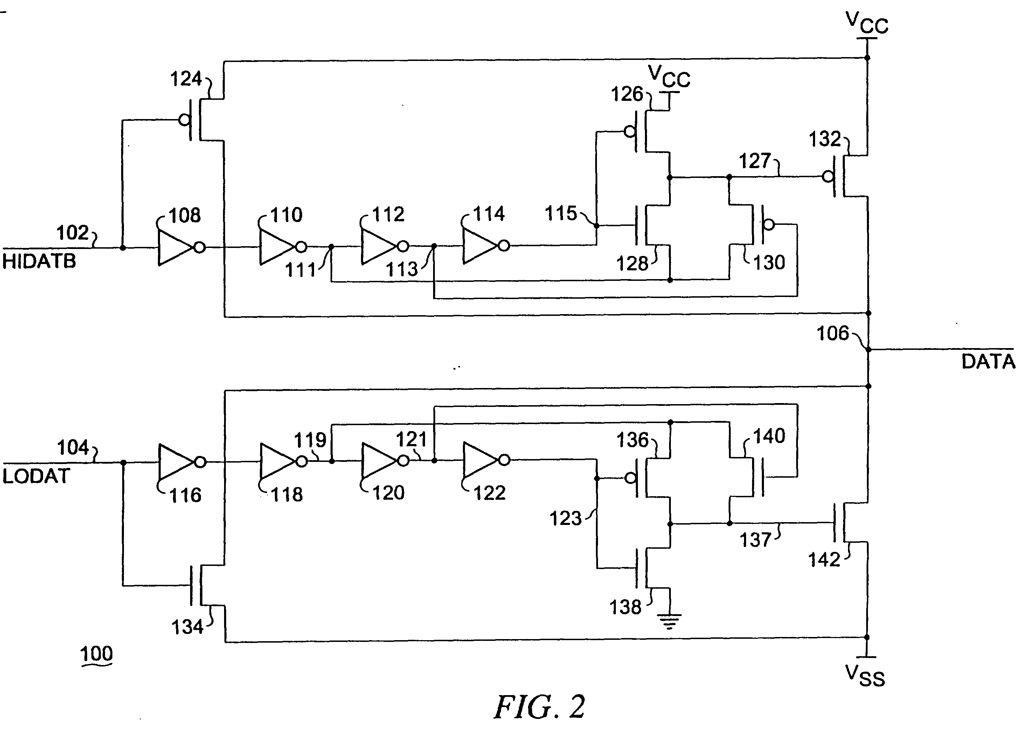

With reference additionally now to Fig. 2, a schematic and logic block representation of a multi-stage data anticipation driver 100 in accordance with one embodiment of the present invention is shown. As in the prior art data driver circuit 10 of the preceding figure, the driver 100 receives HIDATB and LODAT signals on inputs 102 and 104 respectively while providing an output data ("DATA") node 106.

The HIDATB signal on input 102 is applied to the input of a series coupled string of inverting amplifiers 108, 110, 112 and 114 respectively as well as to the gate of p-channel transistor 124 which has its source terminal coupled to a first supply voltage source VCC and its drain terminal coupled to the data node 106. In corresponding fashion, the LODAT signal on input 104 is applied to the input of another series coupled string of inverting amplifiers 116, 118, 120 and 122 respectively as well as to the gate of n-channel transistor 134 which has its source terminal coupled to a second supply voltage source VSS and its drain terminal coupled to the data node 106.

An inverter comprising p-channel transistor 126 and series connected n-channel transistor 128 is coupled between VCC and node 111 intermediate inverting amplifiers 110 and 112. The output of inverting amplifier 114 is supplied to the common connected gates of transistors 126 and 128. Node 127 intermediate transistors 126 and 128 is coupled to the source terminal of p-channel transistor 130 which is connected in parallel with transistor 128. The gate terminal of transistor 130 is driven by the output of inverting amplifier 112 at node 113. The signal on node 127 is applied to the gate terminal of a p-channel transistor 132 which has its source terminal coupled to VCC and its drain terminal coupled to the data node 106.

In like manner, an inverter comprising p-channel transistor 136 and series connected n-channel transistor 138 is coupled between node 119 intermediate inverting amplifiers 118 and 120 and circuit ground. The output of inverting amplifier 122 is supplied to the common connected gates of transistors 136 and 138. Node 137 intermediate transistors 136 and 138 is coupled to the source terminal of n-channel transistor 140 which is connected in parallel with transistor 136. The gate terminal of transistor 140 is driven by the output of inverting amplifier 120 at node 121. The signal on node 137 is applied to the gate terminal of an n-channel transistor 142 which has its source terminal coupled to VSS and its drain terminal coupled to the data node 106.

In operation, when a logic level "1" is to be read form the tri-state driver 100, the signal HIDATB goes "low" while LODAT is held "low" if the previous data was tri-state. Upon HIDATB going "low", transistor 124 turns "on" and starts supplying current to the data node 106. After a predetermined delay, node 111 goes "low" which couples node 127 "low" through transistors 128 and 130, which are both "on". Node 127 going "low" turns "on" transistor 132 which also starts supplying current to the data node 106. The delay between transistors 124 and 132 is represented by inverting amplifiers 108 and 110. This delay helps to minimize *di/dt* to the data node 106. Once node 111 goes "low", node 113 goes "high" which turns "off" transistor 130. After another predetermined delay set by inverting amplifier 114, node 115 goes "low" which turns "off" transistor 128 and turns "on" transistor 126 which takes node 127 "high" and turns "off" transistor 132. With transistor 132 "off", transistor 124 is the only transistor supplying current to the data node 106.

In order to read a logic level "0" on the data node 106, the signal HIDATB goes "high" and LODAT goes "high" assuming the previous data level was "high". HIDATB going "low" turns "off" transistor 124 and causes nodes 111 and 115 to go "high" and node 113 to go "low". With node 113 "low", transistor 130 turns "on" which once again couples node 111 to node 127. With node 115 "high", transistor 128 turns "on" and transistor 126 turns "off". When LODAT goes "high", transistor 134 turns "on" and starts sinking current from the data node 106. After a predetermined delay defined by inverting amplifiers 116 and 118, node 119 goes "high" which couples node 137 "high" through transistors 136 and 140. Node 137 going "high" turns "on" transistor 142 which starts sinking additional current from the data node 106. The delay between transistors 134 and 142 turning "on" helps to minimize *di/dt* associated with current coming out of the data node 106. Once node 119 goes "high", node 121 goes "low" which turns "off" transistor 140. After a predetermined delay set by inverting amplifier 122, node 123 goes "high" which turns "off" transistor 136 and turns "on" transistor 138, which, in turn, takes node 137 "low" turning "off" transistor 142. With transistor 142 "off", transistor 134 is the only transistor sinking current from the data node 106.

Fundamentally, the driver 100 of the present invention comprises a two-stage data driver in which a first stage turns "on" (inducing only a relatively small *di/dt*) followed by a second stage that turns "on" following a predetermined delay providing another relatively small *di/dt.* Following another predetermined delay, the second stage turns "off" which can result in a small -*di/dt* in the output driver comprising transistors 132 and 142, if it is sourcing or sinking current. This then leaves only the first stage driving the output node 106 and only this stage need turn "off" when the opposite data state is read.

The two-stage functionality of the driver 100 is effectuated by the provision of directly driven transistors 124 and 134 in parallel with transistors 132 and 142 respectively, transistors 126, 128, 130, 136, 138 and 140 and the inverting amplifiers 108-122 functioning as delay elements. The combined width/length ("W/L") ratios of transistors 124, 132 and 134, 142 are selected to approximate the size of a single driver transistor which might otherwise be used and transistors 124 and 134 should be of a minimum gate width required to support any direct current ("DC") specification and the initial *di/dt* value. On the other hand, transistors 132 and 142 are preferably maximized in gate width determined by the maximum final *di/dt* as they are used only when switching to a new data state. The sizes of transistors 124 and 132 will also effect the rate of change of current into or out of the data node. Typically, this size should be minimized.

In a particular embodiment of the present invention, various of the transistors may have the following sizes: transistor 124 W=300µ/L=0.8µ; transistor 126 W/L=50µ; transistor 128 W/L=50µ; transistor 130 W/L=10µ; transistor 132 W=300µ/L=0.8µ; transistor 134 W=160µ/L=0.8µ; transistor 136 W/L=50µ; transistor 138 W/L=50µ; transistor 140 W/L=10µ; and transistor 142 W=160µ/L=0.8µ.

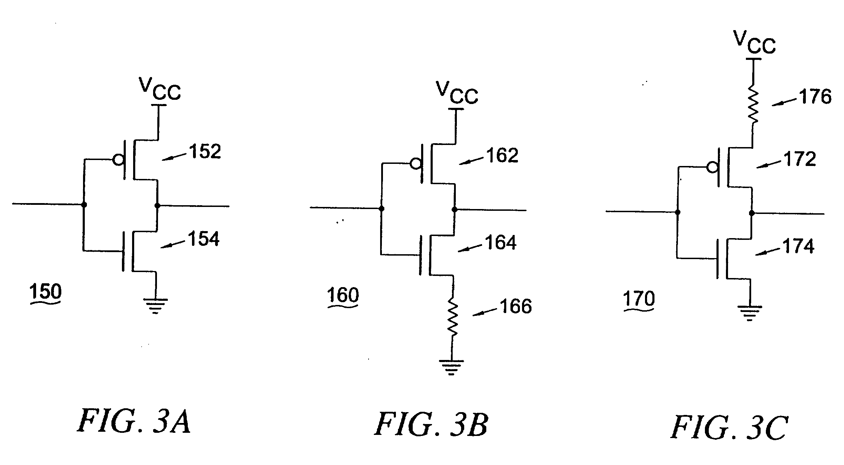

With reference additionally now to Figs. 3A, 3B and 3C, representative schematic diagrams for one or more portions of the inverting amplifiers 108-122 of Fig. 2 are shown in gate level detail for a particular implementation of a multi-stage data anticipation driver for use with a synchronous dynamic random access memory device ("SDRAM"). In this regard, inverting amplifier 108 may be configured as the inverter 150 of Fig. 3A with p-channel transistor 152 having a W/L ratio of 30µ and n-channel transistor 154 having a W/L ratio of 15µ. Inverting amplifier 110 may be configured as the inverter 160 of Fig. 3B with p-channel transistor 162 having a W/L ratio 5µ, n-channel transistor 164 having a W/L ratio of 20µ and resistor 166 having a value of 500 ohms. Inverting amplifier 112 may be configured as inverter 150 of Fig. 3A with both p-channel transistor 152 and n-channel transistor 154 having a W/L ratio of 5µ. Inverting amplifier 114 may further be constructed utilizing a series connection of inverters 150 (Fig. 3A), 170 (Fig. 3C) and 160 (Fig. 3B). In this regard, the transistors 152, 154 may each have a W/L ratio of 5µ, resistor 176 a value of 6000 ohms while transistors 172, 174 each have a W/L ratio of 5µ, while transistors 162, 164 each have a W/L ratio of 5µ and resistor 166 has a value of 6000 ohms.

Inverting amplifier 116 may be configured as the inverter 150 of Fig. 3A with transistors 152 and 154 having a W/L ratio 10µ and 5µ respectively. Inverting amplifier 118 may be configured as the inverter 170 of Fig. 3C with resistor 176 equal to 500 ohms and transistors 172 and 174 having W/L ratios of 20µ and 5µ respectively. Inverting amplifier 120 may be configured as the inverter 150 of Fig. 3A with both transistors 152, 154 having a W/L ratio of 5µ each. Lastly, inverting amplifier 122 may be configured as the combination of inverters 150 (Fig. 3A), 160 (Fig. 3B and 170 (Fig. 3C) with transistors 152, 154, 162 and 164 each having a W/L ratio of 5µ and resistor 166 a value of 6000 ohms while transistors 172, 174 each have a W/L ratio of 50µ and resistor 176 has a value of 6000 ohms.

While there have been described above the principles of the present invention in conjunction with a specific multi-stage data anticipation driver for use with a representative integrated circuit memory device, it is to be clearly understood that the foregoing description is made only by way of example and not as a limitation to the scope of the invention. Particularly, it is recognized that the teachings of the foregoing disclosure will suggest other modifications to those persons skilled in the relevant art. Such modifications may involve other features which are already known per se and which may be used instead of or in addition to features already described herein. Although claims have been formulated in this application to particular combinations of features, it should be understood that the scope of the disclosure herein also includes any novel feature or any novel combination of features disclosed either explicitly or implicitly or any generalization or modification thereof which would be apparent to persons skilled in the relevant art, whether or not such relates to the same invention as presently claimed in any claim and whether or not it mitigates any or all of the same technical problems as confronted by the present invention. The applicants hereby reserve the right to formulate new claims to such features and/or combinations of such features during the prosecution of the present application or of any further application derived therefrom.

## Claims

1. An integrated circuit device including a data driver for receiving an input data signal and supplying the same to an output data node, said data driver comprising:
a first stage driver coupled to receive said input data signal and to said output data node for supplying said input data signal to said output data node; and
a second stage driver also coupled to receive said input data signal and to said output data node for also supplying said input data signal to said output data node.

2. The integrated circuit device of claim 1 wherein said first stage driver comprises an inverter comprising pull-up and pull-down transistors.

3. The integrated circuit device of claim 2 wherein said second stage driver comprises another inverter comprising pull-up and pull-down transistors.

4. The integrated circuit device of claim 3 wherein said input data signal comprises a high data state signal and a low data state signal coupled to a control terminal of said pull-up and pull-down transistors of said first and second stage drivers.

5. The integrated circuit device of claim 4 wherein said high and low data state signals are coupled to said control terminals of said pull-up and pull-down transistors of said second stage driver by means of at least one delay element respectively.

6. The integrated circuit device of claim 3 wherein said pull-up transistors comprise p-channel devices and said pull-down transistors comprise n-channel devices.

7. The integrated circuit device of claim 3 wherein said pull-up and pull-down transistors of said first stage driver are substantially of a minimum gate width sufficient to support a DC current and an initial rate of current change at said output data node.

8. The integrated circuit device of claim 7 wherein said pull-up and pull-down transistors of said second stage driver are substantially of a gate width sufficient to support a maximum final rate of current change at said output data node.

9. The integrated circuit device of claim 1 wherein in response to a change of state in said input data signal said first stage driver is turned on followed by said second stage driver following a first predetermined delay time period.

10. The integrated circuit device of claim 9 wherein said second stage driver is turned off following an establishment of a given data state at said output data node.

11. The integrated circuit device of claim 10 wherein said second stage driver is turned off in response to a second predetermined delay time period.

12. The integrated circuit device of claim 10 wherein said first stage driver is turned off upon receipt of another change of state in said input data signal.

13. The integrated circuit device of claim 11 wherein said first and second predetermined delay time periods are established by the gate delays selected from a plurality of series coupled inverting amplifiers.

14. A method for driving an input data signal to an output data node in an integrated circuit device comprising:
receiving said input data signal at a first stage driver;
coupling said input data signal to said output data node through said first stage driver;
also receiving said input data signal at a second stage driver; and
also coupling said input data signal to said output data node through said second stage driver.

15. The method of claim 14 wherein said step of coupling said input data signal to said output data node is carried out in response to a change of data state in said input data signal.

16. The method of claim 15 wherein said step of also coupling occurs following a first predetermined delay time period.

17. The method of claim 16 further comprising the step of:
de-coupling said input data signal from said output data node through said second stage driver following an establishment of a given data state on said output data node.

18. The method of claim 17 wherein said step of de-coupling said input data signal from said output data node occurs in response to a second predetermined delay time period.

19. The method of claim 18 further comprising the step of:
further de-coupling said input data signal from said output data node through said first stage driver upon receipt of another change of state in said input data signal.

20. The method of claim 18 wherein said first and second predetermined delay time periods are established by means of a number of gate delays selected from a plurality of series coupled inverting amplifiers.

21. The method of claim 14 wherein said step of coupling said input data signal to said output data node further comprises the step of:
controlling an initial rate of current change at said output data node.

22. The method of claim 21 wherein said step of controlling an initial rate of current change at said output data node is carried out by means of sizing a gate width of pull-up and pull down transistors of said first stage driver.

23. The method of claim 14 wherein said step of also coupling said input data signal to said output data node further comprises the step of:
also controlling a maximum final rate of current change at said output data node.

24. The method of claim 23 wherein said step of also controlling a maximum final rate of current changes is carried out by means of sizing a gate width of pull-up and pull-down transistors of said second stage driver.
